# EUROPÄISCHE PATENTSCHRIFT

(11) **EP 3 039 721 B1**
(45) Veröffentlichungstag und Bekanntmachung des Hinweises auf die Patenterteilung: **24.07.2019**
(21) Anmeldenummer: 14755826.6
(22) Anmeldetag: 27.08.2014
(51) Int. Cl.: H01L 31/0216, H01L 31/0392, H01L 31/073, H01L 31/18

(54) **HAFTVERMITTLERSCHICHT FÜR DÜNNSCHICHTSOLARZELLEN**
ADHESION PROMOTING LAYER FOR THIN-FILM SOLAR CELLS
COUCHE FAVORISANT L'ADHÉSION POUR CELLULES SOLAIRES À COUCHES MINCES

(30) Priorität: 30.08.2013 CN 201310537497
(43) Veröffentlichungstag der Anmeldung: 06.07.2016
(73) Patentinhaber: China Triumph International Engineering Co., Ltd., Shanghai 200063 (CN); CTF Solar GmbH, 01099 Dresden (DE)
(72) Erfinder: SIEPCHEN, Bastian, 01099 Dresden (DE); PENG, Shou, 200063 Shanghai (CN)
(74) Vertreter: Kailuweit & Uhlemann Patentanwälte Partnerschaft mbB
(86) Internationale Anmeldenummer: PCT/EP2014/068194
(87) Internationale Veröffentlichungsnummer: WO 2015/028521

(56) Entgegenhaltungen:
- EP-A2- 2 381 485
- WO-A1-00/14812
- WO-A2-2008/112056
- DE-A1- 10 003 491
- DE-A1-102009 023 125
- WU X: "High-efficiency polycrystalline CdTe thin-film solar cells", SOLAR ENERGY, PERGAMON PRESS. OXFORD, GB, Bd. 77, Nr. 6, 1. Dezember 2004 (2004-12-01), Seiten 803-814, XP004661821, ISSN: 0038-092X, DOI: 10.1016/J.SOLENER.2004.06.006

## Beschreibung

Gegenstand der vorliegenden Erfindung sind ein verbessertes Verfahren zur Herstellung von CdTe-Dünnschichtsolarzellen bzw. eines Halbzeugs dafür, das vorsieht, eine zusätzliche Grundierungsschicht aufzutragen, die nach der Frontkontaktschicht auf diese aufgebracht wird, um das Wachstum der folgenden CdS-Schicht zu verbessern sowie eine Dünnschicht Solarzelle nach dem genannten Verfahren.

Bei der Herstellung von Dünnschichtsolarzellen nach dem Stand der Technik wird auf einem Substrat, üblicherweise Glas, eine transparente Frontkontaktschicht (bspw. TCO - transparent conducting oxide) aufgebracht. Auf dieser Frontkontaktschicht wird eine Schicht aus reinem oder modifiziertem CdS (Kadmiumsulfid) abgeschieden, auf die nachfolgend die CdTe-Schicht (Kadmiumtellurid) abgeschieden wird. Abschließend erfolgt das Aufbringen der Rückkontaktschicht.

Das Aufbringen der CdS-Schicht erfolgt nach dem Stand der Technik im CSS-Verfahren (Close spaced sublimation), bei dem das Glassubstrat mit der vorbereiteten Frontkontaktschicht über einen Tiegel mit CdS bewegt wird. Dieser Tiegel ist beheizt und das aufzudampfende Material (CdS) verdampft (sublimiert) aus dem Tiegel und schlägt sich auf der Frontkontaktschicht des Substrates nieder, die auf einer niedrigeren Temperatur gehalten wird, als der Tiegel.

Nähere Untersuchungen haben gezeigt, dass sich das CdS, das im Tiegel als Granulat vorliegt, beim Sublimieren in seine Bestandteile zersetzt (2 CdS-> 2Cd+S₂). Diese Bestandteile erreichen die Oberfläche der Frontkontaktschicht getrennt und verbinden sich dort erneut zu CdS.

Das nachfolgende Aufbringen der CdTe-Schicht erfolgt ebenfalls bevorzugt mit dem CSS-Verfahren.

Abschließend wird der Rückkontakt, vorzugsweise als Schichtfolge, aufgebracht.

Bei dem beschriebenen Verfahren und auch im Folgenden werden Reinigungs-, Temper- und Versiegelungsschritte nach dem Stand der Technik als bekannt vorausgesetzt und nicht näher erläutert. Auch das Aufbringen von Antireflexions- und Schutzschichten (bspw. Rückseitenlaminat oder -glas) wird vorausgesetzt.

Im großtechnischen Einsatz erfolgt die Aufbringung der CdS- und CdTe-Schichten, indem die Substrate mit der vorbereiteten Frontkontaktschicht (die in Richtung der Tiegel zeigt) erhitzt und mit konstanter Geschwindigkeit über die Tiegel hinweggeführt werden, so dass sich CdS und CdTe-Schichten gleichmäßiger Dicke ausbilden. Der Prozess wird nach dem Stand der Technik in hintereinandergeschalteten, beheizten Vakuumkammern ausgeführt, durch die die Substrate auf einem Transportsystem aus Rollen oder Transportbändern, die die Substrate an ihrer seitlichen Kante stützen, bewegt werden.

Bei diesem Prozess wird angestrebt, die CdS-Schicht möglichst dünn zu gestalten, um die Verschlechterung der optischen Eigenschaften der Solarzelle durch diese Schicht zu begrenzen. Gleichzeitig muss jedoch gewährleistet werden, dass die CdS-Schicht keine Fehlstellen (Löcher - pin holes) aufweist, durch die es zu Kurzschlüssen zwischen dem Frontkontakt und der CdTe-Schicht kommen könnte. Nach dem Stand der Technik wird zur Erfüllung dieser beiden Anforderungen eine CdS-Schichtdicke von 80 nm bis 200 nm bevorzugt.

Nachteilig bei der Herstellung der CdS-Schicht ist, dass das Wachstum dieser Schicht sehr langsam erfolgt, da das CdS bzw. dessen Bestandteile aus dem Dampf nur schwer auf der Oberfläche der Frontkontaktschicht haften bleiben. Als Folge muss mehr CdS-Material aus dem Tiegel verdampft werden, als zum Schichtaufbau benötigt wird. Neben den erhöhten Kosten führt dies zur verstärkten Abscheidung von CdS an Orten, für die dies nicht gewünscht ist.

In der EP 2 381 485 A2 wird eine Dünnschicht-Solarzelle mit einem Glassubstrat, einer Frontkontaktschicht, einer Zwischenschicht, einer CdS-Schicht, einer CdTe-Schicht und einer Glas-Abdeckung beschrieben. Dieser Aufbau kann im superstrate-Verfahren erzeugt werden, bei dem auf dem Glassubstrat die Frontkontaktschicht und über dieser die CdS-Schicht und die CdTe-Schicht aufgebracht werden. Die Zwischenschicht dient der Verbesserung der Haftung der CdS-Schicht auf der Frontkontaktschicht, so dass die CdS-Schicht dünn vorgesehen werden kann, ohne die elektrischen Eigenschaften der Solarzelle negativ zu beeinflussen. Die Zwischenschicht hat eine Dicke zwischen 75 nm und 1 µm.

Auch die WO 2008/112056 A2 beschreibt eine Dünnschicht-Solarzelle mit einem solchen Aufbau, wobei die Zwischenschicht zwischen der Frontkontaktschicht und der CdS-Schicht eine Dicke im Bereich von 10 nm bis 500 nm aufweist. Auch hier wird die Solarzelle mit einem superstrate-Verfahren erzeugt.

Im Ergebnis der genannten Probleme ergibt sich die Aufgabenstellung, die Schichtdicke der CdS-Schicht ohne Qualitätsverlust zu reduzieren und das CdS insbesondere im CSS-Verfahren besser auszunutzen. Auch eine Beschleunigung des Beschichtungsprozesses soll so erreicht werden.

Erfindungsgemäß wird die Aufgabenstellung mit einem Verfahren nach Anspruch 1 gelöst. Vorteilhafte Verfahrensweisen sind in den rückbezogenen Unteransprüchen aufgeführt. Die erfindungsgemäß ausgestaltete Dünnschicht-Solarzelle ist in Anspruch 4 offenbart. Vorteilhafte Ausführungsformen dieser Solarzelle sind Gegenstände der rückbezogenen Unteransprüche.

Das erfindungsgemäße Verfahren sieht vor, auf die Frontkontaktschicht der Dünnschicht-Solarzelle eine haftvermittelnde Schicht aufzubringen, die sowohl die Abscheiderate des CdS erhöht, als auch die Homogenität der abgeschiedenen CdS-Schicht verbessert.

Ziel der haftvermittelnden Schicht ist es, die Aufenthaltsdauer der Cd- und/oder der S- Atome (die aus den S₂-Moleküle entstehen) auf der Oberfläche der Frontkontaktschicht zu verlängern und so die Reaktionswahrscheinlichkeit zu CdS zu erhöhen.

Als Haftvermittler kommt vorzugsweise eine dünne Schicht aus Cadmiumtellurid (CdTe), Tellur (Te), Selen (Se) oder Cadmiumselenid (CdSe) oder Gemischen dieser Elemente bzw. Stoffe zum Einsatz. Gemische in diesem Sinne heißt, dass die haftvermittelnde Schicht zu mindestens 10% aus einem oder mehreren der genannten Elemente bzw. Verbindungen besteht. Ganz besonders bevorzugt ist der Einsatz von CdTe in dem Reinheitszustand der auch bei der photovoltaisch aktiven Schicht Anwendung findet.

Erfindungsgemäß wird der Haftvermittler als dünne Schicht oder als Mono-Lage aufgebracht. Somit beträgt die Schichtdicke bei Beginn des Auftrages der CdS-Schicht weniger als 10 nm, besonders bevorzugt weniger als 1 nm, oder ist eine Mono-Lage (einatomare bzw. einmolekulare Schicht). Eine zu dicke haftvermittelnde Schicht wirkt sich negativ auf die optischen Eigenschaften der CdS-Schicht aus.

Untersuchungen haben gezeigt, dass die Nukleation der CdS-Schicht auf dieser Haftvermittlungsschicht homogener ist, als mit dem bisherigen Verfahren. Es ist daher möglich die Schichtdicke des CdS zu reduzieren. Vorteilhaft können Schichtdicken im Bereich von 30 nm bis 100 nm erreicht werden, ohne dass die CdS-Schicht Löcher aufweist. Weiter vorteilhaft kann so der Wirkungsgrad der Solarzellen gesteigert werden.

Messungen haben gezeigt, dass sich durch den Einsatz der haftvermittelnden Schicht die Abscheiderate von CdS auf das Dreifache gegenüber dem Verfahren ohne haftvermittelnde Schicht erhöhen lässt.

Die haftvermittelnde Schicht kann mit Verfahren nach dem Stand der Technik aufgebracht werden. Bevorzugt sind hierbei nasschemische Verfahren oder auch Sputtern.

Ganz besonders bevorzugt wird eine haftvermittelnde Schicht (vorzugsweise eine CdTe-Schicht) eingesetzt, die vorzugsweise auch mit dem CSS-Verfahren aufgetragen wird. Hierbei kommen vorzugsweise Anlagen nach dem Stand der Technik zum Einsatz. In der Anlagenabfolge wird hierzu lediglich ein erster Tiegel vorgesehen, über den das mit der Frontkontaktschicht beschichtete Substrat zuerst hinweggeführt wird. Dabei bildet sich die haftvermittelnde Schicht aus.

Untersuchungen haben gezeigt, dass beim CSS-Verfahren die Adsorption und die Desorption ein Gleichgewicht anstreben. Dieses ist abhängig von der Substrattemperatur (genauer der Temperatur der aufgedampften Schicht). Durch die Regelung der Substrattemperatur kann somit die angestrebte Schichtdicke als selbstregulierender Prozess erreicht werden. Diese angestrebte Schichtdicke ist beim Beginn der Beschichtung mit CdS kleiner als 10 nm oder eine Monolage.

Nach dem Aufbringen der Schicht aus reinem oder modifiziertem CdS auf die haftvermittelnde Schicht kann die Weiterverarbeitung des so gewonnenen Halbzeugs mit Verfahren nach dem Stand der Technik bis zur fertigen Solarzelle erfolgen. So können bspw. die CdTe-Schicht und die Rückkontaktschichtfolge nach bekannten Verfahren aufgebracht werden. Auch Variationen und zusätzliche Schichten oberhalb der Schicht aus reinem oder modifiziertem CdS sind möglich und werden nicht durch den Einsatz der erfindungsgemäßen haftvermittelnden Schicht beeinflusst.

### Figuren

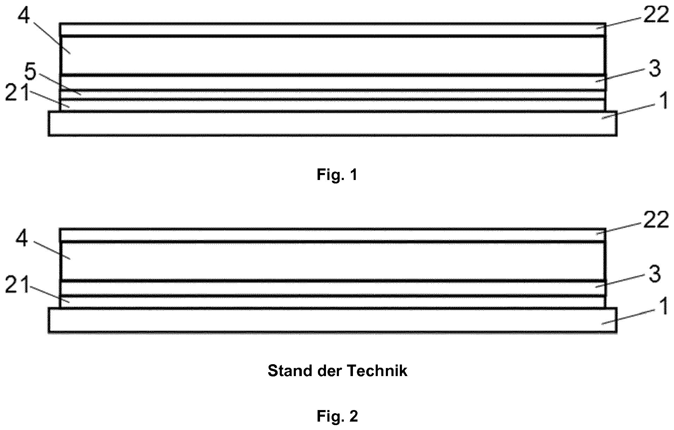

**Fig. 1** zeigt schematisch den Schichtaufbau einer erfindungsgemäßen Solarzelle. Auf dem Glassubstrat (1) ist der Frontseitenkontakt (21) aufgebracht. Darüber befindet sich die dünne haftvermittelnde Schicht (5), auf der dann die aus dem Stand der Technik bekannte Schichtfolge angeordnet ist, die aus CdS-Schicht (3), CdTe-Schicht (4) sowie Rückseitenkontaktschicht (22) besteht.
**Fig. 2** zeigt schematisch den Schichtaufbau einer Solarzelle nach dem Stand der Technik. Diese weist auf dem Substrat (1) eine Schichtfolge aus Frontseitenkontakt (21), CdS-Schicht (3), CdTe-Schicht (4) sowie Rückseitenkontakt (22) auf.

### Ausführungsbeispiel

Ein Substrat (1) mit den Abmessungen (1600 mm x 1200 mm x 3,2 mm) wird mit einer Schicht (21) aus Indium-Zinn-Oxid (ITO) einer Dicke von 250 nm als transparenter Frontkontaktschicht (21) beschichtet.

Anschließend wird das Substrat (1) mit der nach unten gerichteten Frontkontaktschicht (21) in eine Abfolge von Vakuumkammern eingeschleust. Das Substrat (1) wird in der ersten Vakuumkammer auf eine Temperatur von 450°C erhitzt. Dies erfolgt mittels geeigneter Heizvorrichtungen, während das Substrat (1), auf einer Transportvorrichtung ruhend, von dieser durch die erste Vakuumkammer bewegt wird. Das Substrat (1) erreicht die folgende Vakuumkammer und wird, weiterhin von der Transportvorrichtung (Bewegungsgeschwindigkeit 1,5 m/min) mit einem Abstand von 0,5 cm über einen Tiegel mit granulierten CdTe bewegt. Der Tiegel reicht über die gesamte Breite (senkrecht zur Transportrichtung) des Substrates (1) und erstreckt sich in Transportrichtung über eine Länge von 17 cm. Das CdTe im Tiegel ist auf 620°C erhitzt und sublimiert. Die aufsteigenden Gase schlagen sich auf der Frontkontaktschicht (21) des Substrates (1) nieder. Wenn das Substrat (1) den Tiegel passiert hat, weist die Frontkontaktschicht (21) eine vollständige (außer an den Auflagestellen), homogene haftvermittelnde Schicht (5) mit einer Dicke von 5 nm auf. Nach dem Aufbringen dieser haftvermittelnden Schicht (5) erfolgt die Weiterverarbeitung des Substrates (1) nach dem Stand der Technik. Dazu wird das Substrat auf 500°C weiter erhitzt und in die nachfolgenden Behandlungskammern transportiert. So wird nunmehr, ebenfalls im CSS-Verfahren, die CdS-Schicht (3) aufgebracht. Aufgrund der haftvermittelnden Schicht (5) kann dies mit weniger Tiegeln mit CdS als bisher erfolgen. So wird das Substrat (1) nur noch über einen Tiegel mit CdS (Temperatur: 640°C) hinweggeführt. Die erreichte Schichtdicke des CdS beträgt 60 nm. Anschließend wird im CSS-Verfahren die CdTe-Schicht (4) mit einer Dicke von 5000 nm aufgebracht. Danach erfolgt die Aufbringung der Rückkontaktschicht (22) bzw. -schichten mit Verfahren nach dem Stand der Technik. Die Rückkontaktschicht besteht hier aus einer Schichtfolge von Anpassungsschicht und eigentlicher Kontaktschicht. Hier wird eine Anpassungsschicht aus Te (50 nm) durch NP-Ätzen der CdTe Schicht ausgebildet, auf die nachfolgend die Mo-Schicht (250 nm) als eigentliche Kontaktschicht abgeschieden wird.

Abschließend erfolgen die weiteren Verarbeitungsschritte nach dem Stand der Technik.

### Bezugszeichen

- 1: Substrat (Glas)
- 21: Frontkontakt (transparent, TCO)
- 22: Rückkontakt (Metall)
- 3: CdS-Schicht
- 4: CdTe-Schicht
- 5: CdTe-Haftvermittlungsschicht

## Patentansprüche

1. Verfahren zur Herstellung eines Halbzeugs für eine Dünnschicht-Solarzelle, **gekennzeichnet durch** die Schritte:
a. Bereitstellen eines transparenten Substrates (1) mit einer Frontkontaktschicht (21) bzw. Frontkontaktschichtfolge
b. Aufbringen einer Haftvermittlungsschicht (5) auf die Frontkontaktschicht (21) bzw. Frontkontaktschichtfolge
c. Aufbringen einer Schicht (3) aus reinem oder modifiziertem CdS auf die Haftvermittlungsschicht (5),
**dadurch gekennzeichnet, dass** die Haftvermittlungsschicht (5) eine Monolage ist oder eine Dicke kleiner als 10 nm aufweist.

2. Verfahren nach Anspruch 1, **dadurch gekennzeichnet, dass** die Schicht (3) aus reinem oder modifiziertem CdS im CSS (closed spaced sublimation)-Verfahren aufgebracht werden.

3. Verfahren nach Anspruch 2, **dadurch gekennzeichnet, dass** die Schritte b. und c. in einer Folge von Vakuumkammern mit einem gemeinsamen Transportsystem ausgeführt werden.

4. Dünnschicht-Solarzelle aufweisend mindestens die Schichten:
a. transparentes Substrat (1),
b. Frontkontakt (21) oder Frontkontaktschichtfolge,
c. Schicht (3) aus reinem oder modifiziertem CdS,
d. CdTe-Schicht (4),
e. Rückkontakt (22) oder Rückkontaktschichtfolge,
wobei zwischen Frontkontakt (21) oder Frontkontaktschichtfolge sowie der Schicht (3) aus reinem oder modifiziertem CdS eine haftvermittelnde Schicht (5) angeordnet ist, **dadurch gekennzeichnet, dass** die haftvermittelnde Schicht (5) eine Monolage ist oder eine Dicke kleiner als 10 nm aufweist.

5. Dünnschicht-Solarzelle nach Anspruch 4, **dadurch gekennzeichnet, dass** die haftvermittelnde Schicht (5) Tellur, Cadmiumtellurid, Selen, Cadmiumselenid oder deren Gemische aufweist.

## Claims

1. A method for the manufacture of a semi-finished product for a thin-layer solar cell, **characterized by** the following steps:
a. providing a transparent substrate (1) with a front contact layer (21) or front contact sequence of layers
b. applying an adhesion-promoting layer (5) to the front contact layer (21) or front contact sequence of layers
c. applying a layer (3) of pure or modified CdS to the adhesion-promoting layer (5),
**characterized in that** the adhesion-promoting layer (5) is a monolayer or has a thickness of less than 10 nm.

2. The method as claimed in claim 1, **characterized in that** the layer (3) of pure or modified CdS is applied using a CSS (closed spaced sublimation) process.

3. The method as claimed in claim 2, **characterized in that** the steps b. and c. are carried out in a series of vacuum chambers with a common conveying system.

4. A thin-layer solar cell comprising at least the following layers:
a. a transparent substrate (1),
b. a front contact (21) or front contact sequence of layers,
c. a layer (3) of pure or modified CdS,
d. a CdTe layer (4),
e. a back contact (22) or back contact sequence of layers,
wherein an adhesion-promoting layer (5) is disposed between the front contact (21) or the front contact sequence of layers and the layer (3) of pure or modified CdS, **characterized in that** the adhesion-promoting layer (5) is a monolayer or has a thickness of less than 10 nm.

5. The thin-layer solar cell as claimed in claim 4, **characterized in that** the adhesion-promoting layer (5) comprises tellurium, cadmium telluride, selenium, cadmium selenide or mixtures thereof.

## Revendications

1. Procédé de fabrication d'un produit semi-fini pour une cellule solaire à couche mince, **caractérisé par** les étapes :
a. de fourniture d'un substrat transparent (1) comprenant une couche de contact frontal (21) ou une séquence de couches de contact frontal
b. d'application d'une couche promouvant l'adhérence (5) sur la couche de contact frontal (21) ou sur la séquence de couches de contact frontal
c. d'application d'une couche (3) de CdS pur ou modifié sur la couche promouvant l'adhérence (5),
**caractérisé en ce que** la couche promouvant l'adhérence (5) est une monocouche ou présente une épaisseur inférieure à 10 nm.

2. Procédé selon la revendication 1, **caractérisé en ce que** la couche (3) de CdS pur ou modifié est appliquée dans le procédé de CSS (sublimation en espace clos).

3. Procédé selon la revendication 2, **caractérisé en ce que** les étapes b. et c. sont réalisées dans une séquence de chambres à vide comprenant un système de transport commun.

4. Cellule solaire à couche mince comprenant au moins les couches suivantes :
a. substrat transparent (1),
b. couche de contact frontal (21) ou séquence de couches de contact frontal,
c. couche (3) de CdS pur ou modifié,
d. couche de CdTe (4),
e. couche de contact arrière (22) ou séquence de couches de contact arrière,
une couche promouvant l'adhérence (5) étant disposée entre la couche de contact frontal (21) et la séquence de couches de contact frontal ainsi que la couche (3) de CdS pur ou modifié, **caractérisée en ce que** la couche promouvant l'adhérence (5) est une monocouche ou présente une épaisseur inférieure à 10 nm.

5. Cellule solaire à couche mince selon la revendication 4, **caractérisée en ce que** la couche promouvant l'adhérence (5) comprend du tellure, du tellurure de cadmium, du sélénium, du séléniure de cadmium ou leurs mélanges.
